(19) Europäisches Patentamt
European Patent Office
Office européen des brevets

(11) **EP 2 112 476 A1**

(12) **EUROPEAN PATENT APPLICATION**

(43) Date of publication:
**28.10.2009 Bulletin 2009/44**

(51) Int Cl.:
***G01D 5/24*** *(2006.01)* ***H03K 17/955*** *(2006.01)*

(21) Application number: **08154963.6**

(22) Date of filing: **22.04.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **IEE INTERNATIONAL ELECTRONICS &
ENGINEERING S.A.
6468 Echternach (LU)**

(72) Inventors:
• **Lamesch, Laurent**
  **4881, LAMADELAINE (LU)**
• **Hoyer, David**
  **54441, AYL (DE)**

(74) Representative: **Office Freylinger**
**P.O. Box 48
8001 Strassen (LU)**

(54) **Capacitive sensor**

(57) A capacitive sensor comprises a sensing electrode having a capacitance to be measured, a first switching arrangement configured to switch the sensing electrode, in the manner of a switched capacitor, alternately to a first node and to a second node, and a measurement circuit having the second node as an input node and being configured to measure the capacitance of the sensing electrode. The sensor comprises a shielding electrode and a driven shield circuit, which is configured to maintain the shielding electrode substantially at the same voltage level as the sensing electrode when the sensor is operating. The driven shield circuit comprises a second switching arrangement and a buffer amplifier. The second switching arrangement is configured to operate in synchronism with the first switching arrangement, in such a way as to alternately switch the shielding electrode, in the manner of a switched capacitor, to the first node each time when the sensing electrode is switched to the first node and to a third node each time when the sensing electrode is switched to the second node. The buffer amplifier is connected between the second node and the third node to copy the voltage of the second node to the third node.

**Fig. 3**

**Description**

**Technical field**

The present invention generally relates to capacitive sensors, which may be used, for instance, in input devices (e.g. touchpads, capacitive sliders, touch wheels, etc.), proximity sensors or occupant detection systems.

**Background Art**

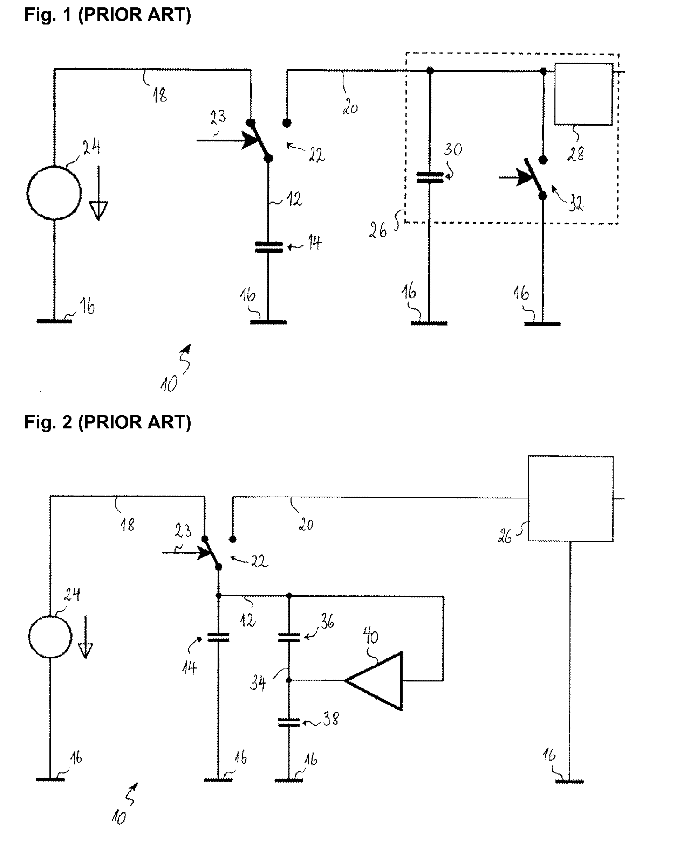

Capacitive sensors are well known and described in numerous publications. US 7,312,616 discloses different capacitive sensors that use the "switched capacitor" principle, which is now briefly explained with reference to Fig. 1.
The capacitive sensor 10 of Fig. 1 comprises a sensing electrode (shown as node 12) forming a capacitor 14 to ground 16 having a variable capacitance $C_s$. Capacitance $C_s$ varies e.g. as a function of the proximity of user's finger. The sensing electrode 12 is connected between a first node 18 and a second node 20 by a switching arrangement 22. The first node 18 is kept at a given potential by a voltage source 24. Switching arrangement 22 is controlled by a control signal applied to control node 23 to periodically switch the sensing electrode12 between first node 18 and second node 20, at a frequency $f_s$. Switching arrangement 22 and capacitor 14 emulate, on average, a resistor of resistance R, with

$$R = 1/(C_s \times f_s). \qquad\qquad (*)$$

This fact is well known and described e.g. in the textbook "Halbleiterschaltungstechnik" by Tietze et al. 12th edition, Springer 2002. As node 20 is connected to the input port of a measurement circuit 26, the latter is driven on average by the voltage source 24 in series with the emulated resistor. Relation (*) can be used to derive the capacitance $C_s$ to be measured from a voltage, current, resistance or frequency measurement. Ways to achieve this are well known in the art.
As discussed in the "background" section of US 7,12,616, the measurement circuit 26 may comprise an analog-to-digital converter 28 connected to node 20 and an integrating capacitor 30 connected between the second node 20 and ground 16. A switch 32 is provided for discharging the integrating capacitor 30 to ground between the measurement cycles. Switch 32 is kept open when the integrating capacitor 30 accumulates charge. The capacitance of this integrating capacitor 30 is chosen considerably larger than the expected capacitance of the sensing electrode 12, which has the effect that the voltage on node 20 changes relatively slowly, i.e. in small steps each time the switching arrangement connects node 20 to the sensing electrode. A similar capacitive sensor is known from the application note AN2394 "CapSense™ Best Practices" by M. Lee, Cypress Semiconductors (see section "CSD Sensing method"). The measurement circuit of this sensor comprises a comparator, which compares the slowly varying voltage on node 20 with a fixed reference voltage and measures the time it takes for the voltage on node 20 to ramp up to the reference voltage. It shall also be noted that the switching arrangement of this sensor is controlled by a pseudo-random sequence.
The sensing electrode is normally a piece of conductive material, which can be approached by an object or human, as a result of which the capacitance of the sensing electrode to ground increases. This increase in capacitance can be sensed to detect the presence of an object or human being, the activation of a key, etc. In most sensor configurations, it is not desired that the sensing electrode is sensitive into all directions. A conductive plate as sensing electrode having a first and a second face couples to ground with both faces if no countermeasures are taken. In order to solve this problem, a so-called driven shield electrode (also called a shielding electrode or guard electrode) is commonly used. The shielding electrode is disposed with respect to the sensing electrode in the direction(s) in which the sensing electrode should not be sensitive. During the measurement, the shielding electrode is actively held at the same electric potential as the sensing electrode by a voltage buffer. The effect of this measure is that the electric field between the sensing and the shielding electrode is substantially cancelled and that therefore, there will be no current flowing between the sensing electrode and the shielding electrode. As a result the sensing electrode only couples to ground with its face(s) that are turned away from the shielding electrode.
Until now, to copy the electric potential on the sensing electrode to the shielding electrode, a buffer amplifier was used, which has its input port connected to the sensing electrode and its output port connected to the shielding electrode. This configuration is shown, for instance in Quantum Research Application Note AN-KD02 "Secrets of a Successful Qtouch™ Design". Fig. 2 shows how this driven shield circuit is implemented in the sensor of Fig. 1. The details of the measurement circuit 26 are not shown in Fig. 2. The shielding electrode is represented by node 34. As can be seen, a capacitance 36 exists between the sensing electrode 12 and the shielding electrode 34 and there is another capacitance 38 between the shielding electrode 21 and ground 16. The shielding electrode 34 is kept at the potential of the sensing electrode 12 by buffer amplifier 40, which has unity gain. It should be noted that Fig. 2 does not show a realistic geometrical configuration.

In case of an ideal buffer 40, this circuit measures the capacitance of capacitor 14, even in presence of non-zero capacitances 36 and 38. In practice, however, this circuit has an important drawback. First, since the switching arrangement 22 abruptly switches sensing electrode 12 between node 18 and node 20, which are at different electric potentials, the buffer amplifier 40 has at its input a square wave with fast rise and fall times. The signal that the buffer amplifier 40 has to copy thus contains high-frequency components. Second, the capacitance 38 can have a considerably large value. Third, the gain of a real buffer amplifier is never perfectly equal to one, especially not at high frequencies. These three issues together imply that buffer amplifier 40 has to drive a load with low impedance, i.e. capacitance 38, at high frequencies, with the result that the potential on shielding electrode 34 is not equal to the voltage on the sensing electrode 12 at all points in time. This again implies that the capacitance measured by the measurement circuit in Fig. 8 is the sum of capacitance $C_s$ and a fraction of capacitance 36, leading to a noticeable measurement error.

**Technical problem**

It is an object of the present invention to provide a capacitive sensor with an improved driven shield circuit, wherein the voltage difference between the sensing electrode and the shielding electrode is reduced with respect to the sensor discussed hereinabove. This object is achieved by a capacitive sensor as claimed in claim 1.

**General Description of the Invention**

A capacitive sensor comprises a sensing electrode having a capacitance to be measured, a first switching arrangement configured to switch the sensing electrode, in the manner of a switched capacitor, alternately to a first node and to a second node, and a measurement circuit having the second node as an input node and being configured to measure the capacitance of the sensing electrode. The sensor further comprises a shielding electrode and a driven shield circuit, which is configured to maintain the shielding electrode substantially at the same voltage level as (i.e. substantially equipotential to) the sensing electrode when the sensor is operating. According to the invention, the driven shield circuit comprises a second switching arrangement and a buffer amplifier. The second switching arrangement is configured to operate in synchronism with the first switching arrangement, in such a way as to alternately switch the shielding electrode, in the manner of a switched capacitor, to the first node each time when the sensing electrode is switched to the first node and to a third node each time when the sensing electrode is switched to the second node. In addition, the buffer amplifier is connected between the second node and the third node to copy the voltage of the second node to the third node. The switching frequency of the switching arrangements is preferably comprised in the range from about 100 kHz to about 1 MHz. Those skilled will appreciate that a measurement circuit configured for measuring the capacitance of a switched capacitor normally allows the voltage on the measurement node (here the second node) only to change to a much lesser extent than the node being switched (here the sensing electrode). Over time, the variations on the measurement node are thus considerably smaller than on the node being switched. Therefore, a buffer amplifier connected as indicated above to drive the shielding electrode can better follow its input voltage. As a result, the error in electric potential between sensing and shielding electrode is reduced, which leads to an improved sensitivity.

Preferably, the measurement circuit comprises means for attenuating voltage changes on the second node with respect to voltage changes on the sensing electrode. Such means may comprise, for instance, an integrating capacitor connected to the second node. Such an integrating capacitor preferably has a capacitance, which is substantially larger than the capacitance between the sensing electrode and ground (which is herein also referred to as capacitance of the sensing electrode) in normal operating conditions. It shall be noted here that the capacitance of the sensing electrode is variable. It is normally possible, however, to estimate a (theoretical) maximum capacitance for the sensing electrode (which is reached if a grounded surface is brought as close to the sensing electrode as the geometry of the sensor permits in operating conditions of the sensor). The capacitance of the integrating capacitor is chosen preferably at least 100 times, more preferably at least 1000 times, larger than this theoretical maximum capacitance of the sensing electrode. To discharge the integrating capacitor, the measurement circuit preferably comprises a switch connected in parallel to the capacitor.

In addition or as an alternative to the integrating capacitor, the means for attenuating voltage changes on the second node may comprise a transconductance amplifier having a first input port connected to the second node and a second input port connected to a reference potential. Such transconductance amplifier produces an output such that the voltage difference between its inputs is minimized. Thus, by keeping the reference voltage constant in time or slowly varying, one achieves that the voltage on the second node remains substantially constant as well.

The capacitive sensor preferably comprises a voltage source connected to the first node and/or at least one of a current source or a current sink connected to the second node.

Preferably, the capacitive sensor comprises a clock connected to the first and second switching arrangement to control the switching operation thereof. It shall be noted that each switching arrangement may comprise one of more electronically controlled switches.

According to a preferred embodiment of the invention, the driven shield circuit comprises an integrating capacitor (referred to as further integrating capacitor irrespective of whether the other integrating capacitor is present or not) connected to the third node. Preferably, the capacitance of the further integrating capacitor is substantially larger than the capacitance between the shielding electrode and ground in normal operating conditions. This capacitance may be variable but it is normally possible to estimate a (theoretical) maximum value it can take during normal operating conditions of the sensor (by assuming that a grounded surface is brought as close to the shielding electrode as the geometry of the sensor permits). To reduce the variations of the capacitance between the shielding electrode and ground, the sensor may comprise a grounded electrode arranged adjacent but insulated from those faces of the shielding electrode that are not turned towards the sensing electrode. The capacitance of the integrating capacitor is chosen preferably at least 100 times, more preferably at least 1000 times, larger than the capacitance expected in normal operating conditions between the shielding electrode and ground. If an integrating capacitor is present on the second node, the ratio of the capacitance of the further integrating capacitor to the expected capacitance between shielding electrode and ground may optionally be chosen in the same range as the ratio of the integrating capacitor to the capacitance of the first electrode. In fact, the capacitance of the further integrating capacitor is preferably chosen depending on the ability of the buffer amplifier to deliver the necessary current pulse required to charge or discharge the third node when the second switching arrangement switches.

Preferably, the third node is connected to an output port of the buffer amplifier by a resistor in order to reduce the risk of instabilities.

Measurement circuits capable of measuring the capacitance of a switched capacitor are known in the art and in principle any such measurement circuit may be used for the purposes of the invention. Examples of such circuits are given, for instance, in the above-cited application notes and US 7,312,616, and are herewith incorporated herein by reference. Preferably, the measurement circuit comprises at least one of an application-specific integrated circuit, a microcontroller, a processor and a field-programmable gate array.

As those skilled in the art will appreciate, the capacitive sensor as proposed by the present invention may be implemented in an input device (e.g. a touchpad, a touchscreen, etc.) or a capacitive occupant detection system.

**Brief Description of the Drawings**

Further details and advantages of the present invention will be apparent from the following detailed description of not limiting embodiments with reference to the attached drawings, wherein:

Fig. 1 is block schematic diagram of a conventional capacitive sensor operating according to the "switched capacitor" principle;

Fig. 2 is block schematic diagram of the capacitive sensor equipped with a conventional driven shield circuit;

Fig. 3 is a block schematic diagram of a capacitive sensor according to a preferred embodiment of the invention;

Fig. 4 is a block schematic diagram of a variant of the capacitive sensor of Fig. 3;

Fig. 5 is a block schematic diagram of an alternative measurement circuit.

**Description of Preferred Embodiments**

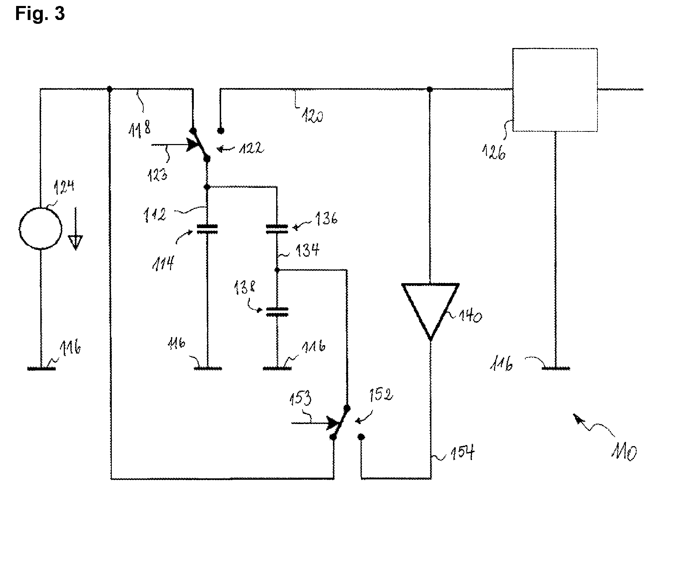

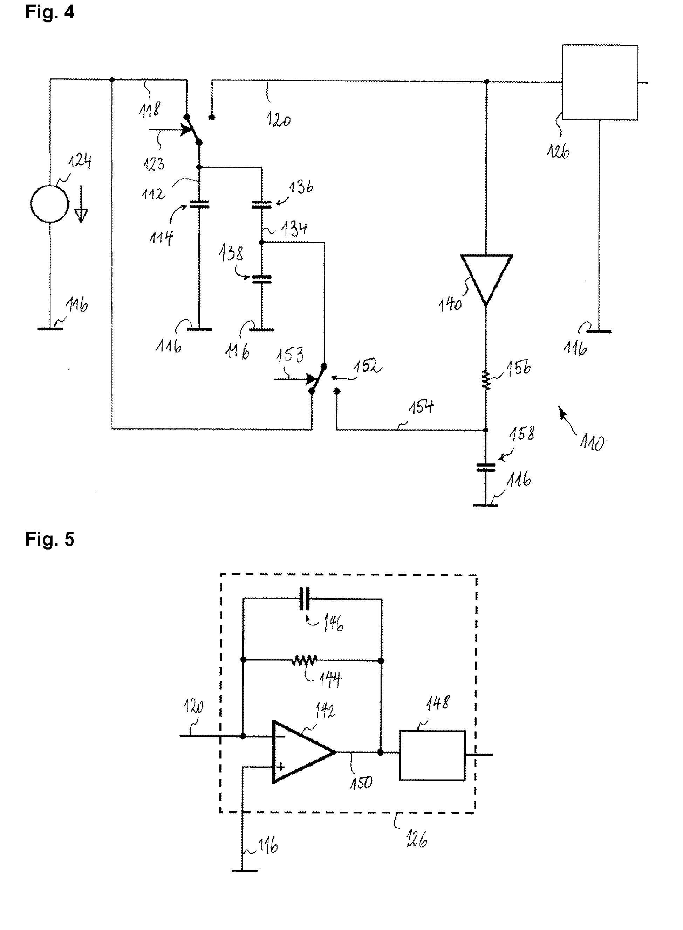

The capacitive sensor of Fig. 3 and its variant of Fig. 4 resemble in many points the sensor 10 discussed with respect to Fig. 1. Accordingly, for similar or same elements, the same reference numerals, preceded by prefix 1, have been used. The capacitive sensor 110 comprises a sensing electrode 112, whose capacitance to ground is to be measured. When the sensor 110 is in operation, the sensing electrode 112 is switched in alternance between a first node 118 and a second node 120, in the manner of a switched capacitor, by a first electronic switch 122 (which may itself comprise a plurality of transistors). The first switch 122 is controlled at its control node 123 by a control signal provided by a clock (not shown). To measure the capacitance of the sensing electrode 112 a measurement circuit 126 is connected to the second node 120. It may e.g. be configured as shown in the dashed box of Fig. 1 or as shown in Fig. 5. Other configurations are of course possible, as explained above. The capacitive sensor 110 further comprises a shielding electrode 134 and a driven shield circuit, which keeps the shielding electrode 134 at the substantially the same voltage level as the sensing electrode 112 when the sensor is operating.

The measurement circuit 126 is configured so as to attenuate voltage changes on the second node 120 with respect to the voltage changes that the sensing electrode 112 undergoes during a measurement cycle. If the measurement circuit 126 is configured as in Fig. 1, the integrating capacitor accumulates charge transferred to it from the sensing electrode and since the capacitance of the integrating capacitor substantially higher than the capacitance of the sensing electrode 112, the voltage on the second node 120 changes only in small steps. If the measurement circuit 126 comprises, as shown in Fig. 5, a transconductance amplifier (operational amplifier 142, the first input of which is connected to the second node 120, and which has a resistor 144 and a capacitor 146 in its feedback branch) and a processor 148, the amplifier 142 keeps the voltage on the second node substantially at the same potential as its second input, which in the example of Fig.5 is connected to ground 116. The transimpedance amplifier converts the average of the current flowing into its input into a proportional output voltage on output node 150. As the average current above is proportional to the resistance emulated by the switch 122 and capacitance 114 as explained above, and as the emulated resistance is a function of the capacitance to be measured, the output voltage on output node 150 is thereby a function of the capacitance to be measured. It may be worthwhile noting that the capacitance of capacitor 146 determines the averaging time.

The driven shield circuit comprises a buffer amplifier and a second electronic switch 152 (which may itself comprise a plurality of transistors). The second switch 152 is controlled at its control node 153 by the same control signal as the first switch 122. Accordingly, the switching arrangements 122 and 153 operate in synchronism. Each time the sensing electrode 112 is switched to the first node 118, the shielding electrode 134 is also switched to that node - either directly (as shown in Figs. 3 and 4) or via the sensing electrode 112. Thus, when the first and second switches 122, 152 are in the shown positions, the shielding electrode 134 is at the same potential as the sensing electrode 112 and the capacitances 136 and 138 - although they may be considerable - have no influence on the charge being accumulated on the sensing electrode 112. Each time the sensing electrode 112 is switched to the second node 120, the shielding electrode 134 is switched to a third node 154, which is connected to the output of the buffer amplifier 140. The buffer amplifier 140 copies the potential of the second node 120 to the third node 154. Thus, whichever the switching state of the switches 122 and 152 is, the voltage difference between the sensing electrode 112 and the shielding electrode 134 is substantially zero, and no appreciable current can flow through the sense-to-guard capacitance 136. Since the voltage buffer 140 is driven at its input by a voltage that has a small rate of change, high frequency components have a much lesser influence on the voltage of the shielding electrode than in the prior art discussed hereinbefore with respect to Fig. 2. As a result, a more accurate capacitance measurement can be made with a sensor according to the invention.

The voltage buffer 140 in Fig. 3 must supply a substantial current pulse when electronic switch 152 switches from the shown position to the opposite one. Since the guard voltage buffer has a substantial output impedance at high frequencies, it may have difficulties to supply the required current in a very short time. This may lead to a difference in electric potential between the second node 120 and the third node 154 shortly after the switching and thus to a measurement error. This problem can be reduced using a modified driven shield circuit, as shown in Fig. 4. The variant of Fig. 4 differs from the one of Fig. 3 only by the additional resistor 156 and integrating capacitor 158. The voltage changes on the third node 154 when the electronic switch 152 switches form the shown position to the opposite one are reduced by the integrating capacitor 158, which preferably has a much higher capacitance to ground than the shielding electrode 134. Resistor 156 separates the capacitor 158 from the voltage buffer output, which might otherwise lead to instabilities.

Apart from the examples of measurement circuits shown in Figs. 1 and 5, there are also other possibilities for implementing such circuits. A common characteristic of such implementations is that they keep the rate of change of the electric potential of the second node at a low level or even at zero. For example, in addition to an integrating capacitor the measurement circuit may comprise a controlled current sink, which is controlled in such a way by a feedback circuit that the second node 120 remains at a predefined voltage level, e.g. the voltage on the first node 118 divided by 2. In this case, the current drained by the current sink is equal to the quotient of half the voltage of the first node by the resistance emulated by the switched capacitor. Accordingly, the drained current is proportional to the capacitance to be measured. In the end the capacitance of the sensing electrode may be determined from the control signal fed to the current sink. As an alternative to a controlled current sink, a controlled current source may be connected to the second node. It should be noted that in both cases, the first node need not be connected to a voltage source but could as well be connected to ground. However, the reference voltage then has to be chosen different from ground potential.

**Claims**

1. A capacitive sensor comprising
    a sensing electrode having a capacitance to be measured;
    a first switching arrangement configured to switch said sensing electrode, in the manner of a switched capacitor, alternately to a first node and to a second node;
    a measurement circuit having said second node as an input node and being configured to measure the capacitance of said sensing electrode;
    a shielding electrode; and
    a driven shield circuit including a buffer amplifier, said driven shield circuit being configured to maintain said shielding electrode substantially equipotential to said sensing electrode;

characterized in that said driven shield circuit comprises a second switching arrangement configured to operate in synchronism with said first switching arrangement so as to switch said shielding electrode, in the manner of a switched capacitor, alternately to said first node when said sensing electrode is switched to said first node and to a third node when said sensing electrode is switched to said second node, said buffer amplifier being connected between said second node and said third node to copy the voltage of said second node to said third node.

2. The capacitive sensor of claim 1, wherein said measurement circuit comprises means for attenuating voltage changes on said second node with respect to voltage changes on said sensing electrode.

3. The capacitive sensor of claim 2, wherein said means for attenuating voltage changes on said second node comprises an integrating capacitor connected to said second node.

4. The capacitive sensor of claim 3, comprising a switch connected in parallel to said capacitor to discharge said integrating capacitor.

5. The capacitive sensor of any of claims 2 to 4, wherein said means for attenuating voltage changes on said second node comprises a transconductance amplifier having a first input port connected to said second node and a second input port connected to a reference potential.

6. The capacitive sensor of any one of claims 1 to 5, comprising a voltage source connected to said first node.

7. The capacitive sensor of any of claims 1 to 6, comprising at least one of a current source or a current sink connected to said second node.

8. The capacitive sensor of any of claims 1 to 7, comprising a clock connected to said first and second switching arrangement to control the switching operation thereof.

9. The capacitive sensor of any of claims 1 to 8, wherein said driven shield circuit comprises a further integrating capacitor connected to said third node.

10. The capacitive detection circuit of claim 9, wherein said third node is connected to an output port of said buffer amplifier by a resistor.

11. The capacitive sensor of any of claims 1 to 10, wherein said measurement circuit comprises at least one of an application-specific integrated circuit, a microcontroller, a processor and a field-programmable gate array.

12. An input device, e.g. a touchpad, comprising a capacitive sensor according to any one of claims 1 to 11.

13. A capacitive occupant detection system, comprising a capacitive sensor according to any one of claims 1 to 11.

**Fig. 1 (PRIOR ART)**

**Fig. 2 (PRIOR ART)**

**Fig. 3**

**Fig. 4**

**Fig. 5**

Europäisches
Patentamt

European
Patent Office

Office européen
des brevets

**EUROPEAN SEARCH REPORT**

Application Number

EP 08 15 4963

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/004488 A1 (BAXTER LARRY K [US]) 8 January 2004 (2004-01-08) * paragraph [0008] * * paragraph [0095] - paragraph [0098] * * paragraph [0112] - paragraph [0115] * * figures 12,14 * | 1-4,6,8, 12,13 | INV. G01D5/24 H03K17/955 |
| A | | 5,7,9-11 | |

-----

TECHNICAL FIELDS SEARCHED (IPC)

G01D
H03K

The present search report has been drawn up for all claims

| Place of search | Date of completion of the search | Examiner |
|---|---|---|
| The Hague | 6 November 2008 | Chapple, Ian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 08 15 4963

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2008

| Patent document cited in search report | Publication date | Patent family member(s) | Publication date |
|---|---|---|---|
| US 2004004488 A1 | 08-01-2004 | US 2005099188 A1 | 12-05-2005 |

EPO FORM P0459

For more details about this annex : see Official Journal of the European Patent Office, No. 12/82

## REFERENCES CITED IN THE DESCRIPTION

**Patent documents cited in the description**

- US 7312616 B

- US 712616 A

**Non-patent literature cited in the description**

- **M. Lee.** CapSense™ Best Practices. *Cypress Semiconductors*